# EUROPEAN PATENT APPLICATION

(11) **EP 4 672 547 A1**
(43) Date of publication of application: **31.12.2025**
(21) Application number: 24214070.5
(22) Date of filing: 20.11.2024
(51) Int. Cl.: H02J 7/00, G01R 31/36

(54) **BATTERY MANAGEMENT SYSTEM**

(30) Priority: 25.06.2024 US 202418753062
(71) Applicant: Antigravity Batteries LLC, Gardena, CA 90248 (US)
(72) Inventor: Schafer, Scott, Gardena, 90248 (US)
(74) Representative: Meissner Bolte Nürnberg

(57) **Abstract**

A battery management system (10) monitors an electrical energy level of a battery (12) associated with a motor and compares the monitored electrical energy level to a minimum level of stored electrical energy required to start the motor. Upon determining that the battery's monitored electrical energy level is less than or equal to the minimum required level of stored electrical energy to start the motor, the system may place the battery into a hibernation mode such that it may be used to start the motor at a later date. The system includes a wireless communications module (104) that the user may use via a mobile application running on a smart device (112, 114) to trigger the system to bring the battery out of hibernation and to use the battery to start the motor.

## Description

### Field of the Invention

This invention relates to battery management systems, including a battery management system that places the battery into a hibernation mode as necessary.

### Background

Batteries are used to start motors (*e.g.,* combustion vehicle motors) by providing electrical energy to a starter device that converts the electrical energy into mechanical energy that may be used to crank start the motor.

When such batteries are discharged to a certain level (*e.g.,* due to an over discharging event such as having the vehicle lights left on for an extended period of time), the battery may no longer have the stored energy capacity to start the vehicle. In such cases, the battery may require a jump start, a quick charge, and/or may need to be replaced. This process is oftentimes very inconvenient, time consuming, and even dangerous. In fact, many vehicle owners do not have the proper knowledge or experience to perform such actions, and as such, require additional assistance (*e.g.,* road-side assistance that may be expensive and time consuming).

Accordingly, there is a need for a battery management system that may determine an over discharging event of a battery and that may place the battery into a hibernation mode before the battery is completely discharged, *e.g.,* while the battery still maintains enough stored energy to start the vehicle at a later date.

### Summary of the Invention

According to the invention, a system for managing a battery comprises
a controller including a wireless communication module;
an electrical measurement system electrically configured with the battery and in communication with the controller; the controller adapted to:
   measure, using the electrical measurement system, a stored electrical energy level of the battery;
   store the measured stored electrical energy level in memory;
   determine a minimum amount of stored electrical energy required to start a motor associated with the battery at least one time;
   determine if the electrical energy level stored in memory is equal to or less than the determined minimum amount of stored electrical energy required to start the motor at least one time;
   upon a determination that the electrical energy level stored in memory is equal to or less than the minimum amount of stored electrical energy required to start the motor at least one time, then:
      place the battery into a hibernation mode;
      receive, by the wireless communication module, a first wireless communication from a user of the battery to take the battery out of the hibernation mode; and take the battery out of the hibernation mode.

In a preferred embodiment, the controller is further adapted to, upon the determination that the stored electrical energy level in memory is equal to or less than the minimum amount of stored electrical energy required to start the motor at least one time, send, using the wireless communication module, a second wireless communication to the user of the battery regarding a first status of the battery.

Preferably, the first status of the battery includes information based at least in part on the electrical energy level stored in memory.

Preferably, the information includes a notification that the battery has been placed in the hibernation mode.

In a preferred embodiment, the controller is further adapted to, after the battery has been taken out of the hibernation mode, send, using the wireless communication module, a third wireless communication to the user of the battery notifying the user that the battery has been taken out of the hibernation mode.

In a preferred embodiment, the controller is further adapted to, after the battery is taken out of the hibernation mode, electrically configure the battery with the motor; and use the battery to start the motor.

In a preferred embodiment, the first wireless communication is a Bluetooth communication.

Preferably, the Bluetooth communication is initiated from an electronic device associated with the user.

Preferably, the electronic device is a smart device running at least one mobile application that implements the Bluetooth communication.

In a preferred embodiment, when the battery is placed into the hibernation mode, the battery is electrically disconnected from at least one current drawing load.

Preferably, the at least one current drawing load includes one or more current drawing loads associated with the motor and/or the at least one current drawing load includes one or more current drawing loads associated with a battery management system.

In a preferred embodiment, the minimum amount of stored electrical energy required to start the motor at least one time includes a minimum amount of stored electrical energy required to start the motor at least one or more times over a predefined period of time.

Preferably the at least one or more times includes at least five times and/or the predefined period of time includes at least sixty days.

Further embodiments result from the description below.

### Brief Description of the Drawings

Other objects, features, and characteristics of the present invention as well as the methods of operation and functions of the related elements of structure, and the combination of parts and economies of manufacture, will become more apparent upon consideration of the following description and the appended claims with reference to the accompanying drawings, all of which form a part of this specification. None of the drawings are to scale unless specifically stated otherwise.
**FIG. 1** shows an overview of a battery management system in accordance with exemplary embodiments hereof; and
**FIG. 2** shows a workflow of a battery management system in accordance with exemplary embodiments hereof.

### Detailed Description of Exemplary Embodiments

The current invention includes a battery management system that continually monitors a battery's operating parameters to ensure that the battery (e.g., a car battery) continues to have enough electrical energy stored within the battery's cells to start an associated motor and/or machine (e.g., a car) as needed. As will be described herein, the battery management system may determine to place the battery into a hibernation mode when the stored energy within the battery reaches a predetermined threshold. The battery management system also may include various communications capabilities to communicate the battery's operational parameters to a user (e.g., via Bluetooth to a user's smartphone), to notify the user that the battery has been placed in hibernation mode, and to enable the user to intentionally bring the battery out of hibernation mode so that the battery may be used (*e.g.,* to start a car). The battery management system may include other functionalities as described herein.

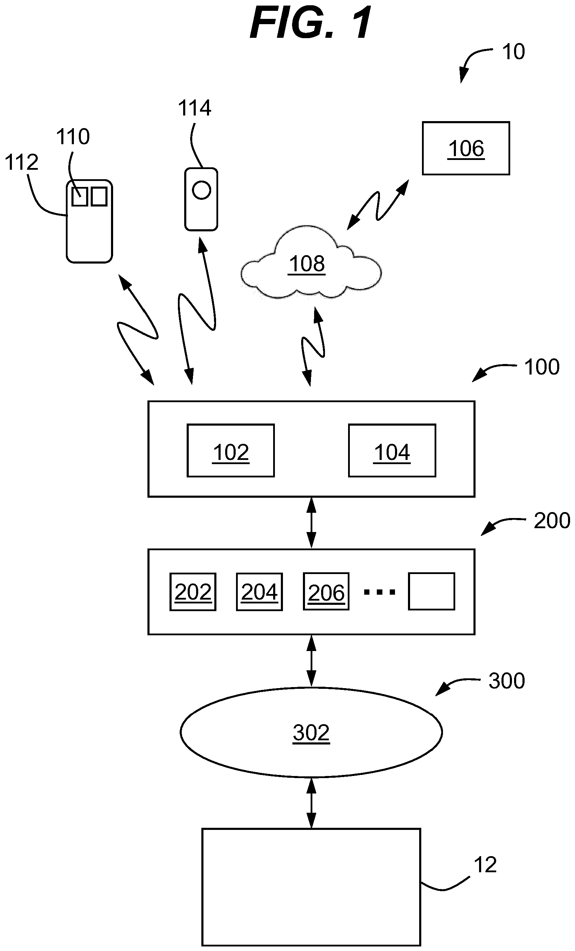

**FIG. 1** shows a block diagram of a battery management system **10** (BMS **10)** configured to monitor and generally manage the performance and various functionalities of a battery **12.**

In some embodiments, as shown in **FIG. 1****,** the battery management system **10** (also referred to herein as the system **10**) includes a controller **100,** a measurement system **200,** and a hardware assembly **300.** In general, the hardware assembly **300** provides physical connections (*e.g*., electrical connections) between the measurement system **200** and the battery **12.** As described herein, the controller **100** controls the measurement system **200** to monitor one or more operating parameters and/or characteristics of the battery **12** via the hardware assembly **300** during the battery's operation. The controller **100** receives and analyzes the measurement information from the measurement system **200.** If the controller **100** detects a problem with the battery **12,** the controller **100** may manage and/or control the battery **12** accordingly. For example, if the battery **12** is a starting, light, and ignition (SLI) battery **12** designed to power the electrical systems of a vehicle, and if the controller **100** determines that the battery **12** is experiencing over-discharging, the controller **100** may determine an optimal condition to place the battery **12** into a hibernation mode such that the enough charge may remain in the battery **12** for jump starting the vehicle at a future date. The system **10** also may include other elements and/or may perform other activities as described herein.

In some embodiments, the battery management system **10** is designed to manage any type of battery **12,** including without limitation, lithium batteries (*e.g*., Lithium Iron Phosphate, Lithium Sodium, and other types of Lithium batteries). Other battery chemistries also may be supported by the system **10.** In some embodiments, the battery **12** may include one or more battery packs each including one or more cells. The supported batteries **12** may include starting, lighting, and ignition (SLI) batteries used in combustion engine vehicles (*e.g*., cars, trucks, motorcycles, boats, tractors, heavy equipment, farm equipment, and/or other types of vehicles). The supported batteries **12** also may include batteries used with generators, compressors, pumps, and/or other types of equipment. The supported batteries **12** also may include batteries used with electric vehicles (EV) such as the primary battery, the secondary battery (typically used for computer backup), other batteries, and any combinations thereof.

For the purposes of this specification, the battery management system **10** will be described primarily with respect to its use with batteries **12** associated with combustion engine vehicles such as cars. However, it is understood that this is for demonstration and that the system **10** may be used with any battery **12** that may benefit from its functionalities. It also is understood that the scope of the system 10 is not limited in any way by the type of batteries **12** that it may be used with.

In some embodiments, the system **10,** *e.g.*, the controller **100** and the measurement system **200,** is contained within a housing that may be installed onto and/or otherwise integrated with the battery **12** using the hardware assembly **300.** The hardware assembly **300** may include electrical connectors, electrical lines (*e.g*., cables, wires, etc.), and/or other connection mechanisms.

In some embodiments, the controller **100** includes a processor (*e.g*., a CPU, a microprocessor, a microcontroller, etc.), memory, supporting chipsets and circuitry, and/or other elements as required. The controller **100** also may include software **102** to perform the functionalities as required by the system **10** as well as operating systems, firmware, and other software as needed. The software **102** may include software drivers to interface with the measurement system **200,** as well as analysis software to analyze the measurement data. The software **102** also may be used to control and manage one or more functionalities of the battery **12** as described herein (*e.g.*, battery cell balancing, etc.).

In some embodiments, the controller **100** also includes a communication module **104** equipped with wireless communication modules such as, but not limited to, Bluetooth, Wi-Fi, cellular, satellite, radio frequency (RF), micro- and/or millimeter wave, Internet, LAN, WAN, infrared, other types of communication modules implementing other communication protocols, and/or any combinations thereof.

In some embodiments, as shown in **FIG. 1****,** the system **10** also may include a cloud platform **106** (also referred to as a cloud server, backend system, backend, or controller) accessible through a network **108** such as the Internet, LAN, WAN, wireless communication systems, cellular communication systems, telephony or other types of communication systems or protocols. The backend system **106** preferably includes one or more servers with one or more software systems including one or more applications and one or more databases. The one or more software systems may include operating systems, system software, web server software, social networking software, communication software, software applications, scripts, firmware, other types of software systems, and any combinations thereof.

In some embodiments, the system **10** may be accessed and/or controlled by one or more users **Un** (*e.g*., via the network **102,** Bluetooth, cellular, Wi-Fi, radio frequency (RF), micro- and/or millimeter wave, satellite communications, infrared, etc.) using one or more applications **110** (*e.g*., a mobile application or "app", a browser, and/or other type(s) of applications) running on one or more computing devices **112** (*e.g*., client devices such as smart phones, tablet computers, smart watches, laptop computers, desktop computers, mobile media players, etc.). The system **10** also may be accessed and/or controlled by a user using a dedicated remote-control unit **114** (*e.g*., a fob) using Bluetooth, radio frequency (RF), micro- and/or millimeter wave, cellular, satellite, Wi-Fi, infrared, etc. This will be described in detail in other sections.

In some embodiments, as shown in **FIG. 1****,** the measurement system **200** includes a voltage measurement module **202** designed to measure voltage, a current measurement module **204** designed to measure current, a temperature measurement module **206** designed to measure temperature, and/or other type(s) of measurement modules.

In some embodiments, as shown in **FIG. 1****,** the hardware assembly **300** includes one or more electrical lines **302** (*e.g*., electrical cables, electrical wires, etc.), one or more electrical connectors **304,** and other electrical connection elements. In some embodiments, the electrical lines **302** are configured to electrically connect the various modules of the measurement system **200** to the battery **12** in order to measure the operating parameters of the battery **12.**

It is understood that the electrical arrangement between the system **10** and the battery **12** may include a centralized architecture (wherein all of the battery packs are connected to the system **10** directly), a modular topology, a primary/subordinate topology, a distributed topology, and/or other types of suitable configurations.

In some embodiments, the controller **100** controls the voltage measurement module **202** to measure one or more voltages of one or more of the battery pack's cells, the current measurement module **204** to measure one or more currents of one or more of the battery pack's cells, and/or the temperature measurement module **206** to measure one or more temperatures of one or more of the battery pack's cells. The resulting measurement data is then communicated to the controller **100** and used to calculate one or more battery parameters.

In some embodiments, the measured and/or calculated battery parameters may include:
1. Voltage (*e.g.,* minimum, and/or maximum cell voltages, real time, historical (*e.g.,* prior 30 days), etc.).
2. Current level being drawn in real time;
3. State of charge (SoC) or depth of discharge (DoD) (*e.g.,* the speed of discharge in real time and over time (*e.g.,* over days, weeks, etc.));
4. State of health (SoH) (remaining capacity of the battery as a fraction of the original capacity);
5. State of power (SoP) (the amount of power available for a defined time interval given the current power usage, temperature, and other conditions);
6. State of safety (SOS);
7. Maximum charge current as a charge current limit (CCL);
8. Maximum discharge current as a discharge current limit (DCL);
9. Energy delivered since last charge or charge cycle;
10. Internal impedance of each cell (to determine open circuit voltage);
11. Charge delivered or stored (also referred to as coulomb counting);
12. Total operating time since first use;
13. Total number of cycles;
14. Temperature of each battery pack (internal and external);
15. Coolant flow for air or liquid cooled batteries;
16. Cranking voltage drop upon starting of engine;
17. Voltage sag upon engine starting and corresponding required current;
18. Energy required to start the vehicle;
19. Run time remaining for given current load;
20. Batter cell balancing and status thereof (*e.g.,* perform cell balancing); and
21. Other parameters.

In some embodiments, the controller **100** may make available at least some of the measurement data and/or at least some of the calculated battery parameters to the user of the system **10** via the controller **100,** *e.g.,* via the mobile application **110** in communication with the controller **100** and running on a user's electronic device **112** (*e.g.,* cell phone, tablet computer, laptop computer, desktop computer, etc.).

In addition, in some embodiments, the controller **100** (*e.g.,* via the mobile application **110)** may alert the user of any problems occurring with the battery **12** in real time (*e.g.,* if the battery **12** is being discharged at a high rate, if the voltage and current draws are too high, etc.).

As is known, a battery stores electrical energy. In addition, when a battery is used to start a vehicle (*e.g.,* a car battery configured with an associated car's engine) the battery provides an electrical voltage and current to the car's starter which converts the electrical energy provided by the battery into mechanical energy. This mechanical energy is then used to crank the starter to start the car's engine. After the engine starts, the car's alternator produces an electric current that replaces the energy the starter drew from the battery. Given the above, in order to start a car using the car battery, the car battery must have enough stored electrical energy to crank the starter to start the car. If the battery does not have sufficient stored electrical energy (*e.g.,* due to an over discharge caused by, *e.g.,* leaving the headlights on), it may not be able to start the car and the battery may be referred to as "dead". When this happens, the car may require a jumpstart to provide the needed electrical energy, or a replacement battery to provide the energy to start the car.

To avoid such a circumstance, in some embodiments, the system **10** may continually monitor the pertinent battery parameters described herein to determine a real-time health status of the battery **12.** In some embodiments, the system **10** specifically monitors battery parameters that may indicate that the battery **12** is being over discharged and may soon not include enough stored energy to start the car if needed to do so.

In some embodiments, the system **10** measures and/or calculates, on a continual basis, how much electrical energy is required to start the particular car associated with the particular battery. That is, each time the car is started using the battery **12,** the system **10** may measure and/or calculate the amount of energy that the battery **12** provided for the car to start. The system **10** also may measure and/or calculate other parameters that may influence how much energy is required to start the car, *e.g.,* how much time has lapsed since the car was last started, the internal and/or external temperature of the battery **12** at the time of starting the car, etc. The system **10** may store this data in the controller **100** along with pertinent supplementary data associated with the parameter such as a date and time stamp. In this way, the controller **100** may save this data over time in order to build a data base of historical data regarding these and other parameters.

In some embodiments, using the data described above, the system **10** may determine a minimum amount of energy that the battery **12** must have stored (and therefore be able to provide to the car starter) in order to start the car engine. In some embodiments, the system **10** may determine the minimum amount of energy E_{M} that the battery **12** must have stored in order to start the car engine a particular number of times **N** (*e.g.,* 5 times) over a particular period of time **T** (*e.g.,* over the next 60 days).

In some embodiments, as the system **10** continues to monitor the status of the battery **12,** if the system **10** determines that the amount of stored energy within the battery **12** (*e.g.,* due to overcharging of the battery **12**) is equal to the minimum amount of energy **E_{M}** required to start the car engine the number of times **N** over the particular period of time **T,** the system **10** may place the battery **12** into a hibernation mode.

In some embodiments, hibernation mode may set the battery **12** into a low quiescent current draw state by electrically disconnecting energy drawing loads from the battery **12.** These loads may include all or some elements of the vehicle (*e.g.,* the lights that were left on may be disconnected to remove the draw), as well as elements of the controller **100** and of the measurement system **200.** In some embodiments, the low quiescent current draw of the battery **12** while in hibernation mode also may be taken into consideration during the calculation of the minimum amount of energy **E_{M}** required to start the car engine the number of times **N** over the particular period of time **T.** Furthermore, if the system **10** is to communicate with the user wirelessly (*e.g.,* via a Bluetooth connection with the user's device **112** and mobile application **110**) while the battery **12** is in hibernation mode (*e.g.,* to initiate a battery wake-up as described below), the system **10** also may take into consideration the amount of energy required for the Bluetooth communication when calculating **E_{M}.**

Once in hibernation mode, the battery **12** may not be used until the user of the system **10** initiates a wake-up (*e.g.,* an emergency start) of the battery **12.** Once the wake-up is initiated, the minimum amount of energy **E_{M}** stored within the battery **12** may be used to start the vehicle.

In some embodiments, the system **10** includes a wireless wake-up functionality that enables the user to initiate the wake-up of the battery **12** wirelessly and without physically interacting with the battery **12** or with the vehicle. In some embodiments, the user may initiate the wireless wake-up of the battery **12** using the mobile application **110** running on an electronic device **112** (*e.g*., on the user's smartphone). In some embodiments, the electronic device **112** and/or the mobile application **110** may interface with the system **10** using Bluetooth communications protocols. In this case, the user may initiate the wake-up on the mobile application **110** by simply running the mobile application **110** on his/her device **112** and instructing the mobile application **110** (*e.g*., via the device's touchscreen or other control mechanisms) to send the wake-up command(s) to the system **10** via Bluetooth. Upon receiving the Bluetooth command signal, the system **10** may electrically connect the battery **12** to the electrical system of the vehicle (*e.g*., to the car's starter) such that the battery **12** may provide the required energy to crank the starter and start the car. The battery **12** may have this amount of energy available for use because of the fact it was placed into hibernation mode while still having the minimum amount of energy **E_{M}** required to start the car engine the number of times **N** over the particular period of time **T.**

In some embodiments, once the system **10** has brought the battery out of hibernation mode and has electrically connected the battery **12** with the car's starter, the mobile application **110** may instruct the user to start the car in the standard fashion, *e.g.,* by using his/her ignition key. In this case, the battery **12** may provide its available stored electrical energy to the starter and the car may be started.

In addition, it is understood that if the electronic device **112** (*e.g.,* the user's smartphone) is capable of utilizing other wireless communication protocols (*e.g.,* radio frequency (RF), micro- and/or millimeter wave, satellite, infrared, etc.), and because the system **10** also may be designed to communicate with the device **112** using such communication protocols, the device **112** may communicate the wake-up command using any such technologies.

In some embodiments, the user may use a dedicated remote-control unit **114** (*e.g.,* a fob) to initiate the wake-up of the battery **12** via the system **10.** For example, in some embodiments, the remote-control unit **114** may interface with the system **10** via Bluetooth, cellular, Wi-Fi, radio frequency (RF), micro- and/or millimeter wave, satellite, infrared, by using other wireless communication protocols, and/or by using any combinations of the above. The remote-control unit **114** may include one or more control mechanisms (*e.g*., a button) that when activated may send the wake-up command to the system **10.** The system **10** may then electrically connect the battery **12** to the car's starter such that the user may start the car in the traditional manner.

In some embodiments, the system **10** *(e.g.,* the controller **100),** may include an access point *(e.g.,* located on the top or cap of the battery **12**) that the user may easily access *(e.g.,* by opening the hood of the car) and that may include a control mechanism *(e.g.,* a physical button) that when activated *(e.g.,* pressed) may command the system **10** to wake-up the battery **12.** Once the user activates the control mechanism, the system **10** may electrically connect the battery **12** to the car's starter such that the user may start the car in the traditional manner. This method may be beneficial if the user's device **112** and/or remote-control **114** is unavailable, out of charge, etc.

In some embodiments, the user may electrically connect an external charging unit to the battery **12** and/or to the system **10** to initiate the battery wake-up. In this case, when the external charging unit is connected to the battery **12** and/or to the system **10,** the system **10** may recognize the available charge from the charging unit and may electrically connect the charging unit to the battery **12** such that the battery **12** may receive a charge from the charging unit. The system **10** also may electrically connect the battery **12** to the car's starter such that the available charge from the charging unit may be used to start the car in the traditional manner.

In some embodiments, the user may initiate the battery wake-up by electrically connecting an external battery in parallel with the battery's electrical terminals. The system **10** may recognize the available charge from the external battery and may electrically connect the external battery to the battery **12** such that the battery **12** may receive a charge from the external battery. The system **10** also may electrically connect the battery **12** to the car's starter such that the available charge from the external battery may be used to start the car in the traditional manner.

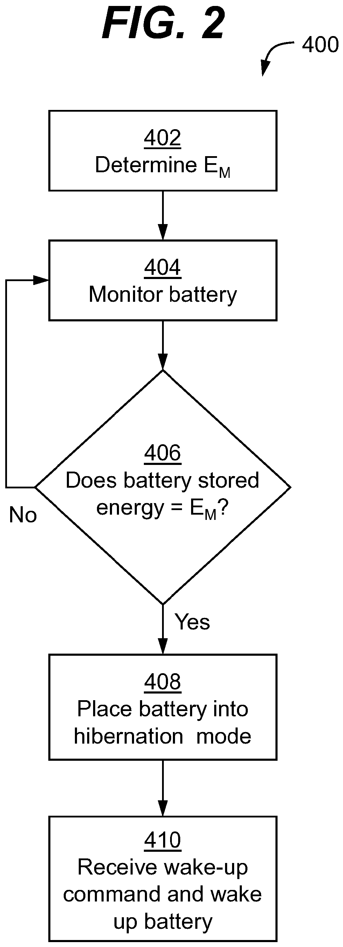

The above-described actions **400** are shown in **FIG. 2** and are summarized below:

At **402** the system **10** may measure and/or calculate the minimum amount of energy **E_{M}** that the battery **12** must have stored and thereby be able to provide in order to start the car engine a particular number of times N over a particular period of time **T.**

At **404,** the system **10** may continually monitor the amount of stored energy that the battery may have available to provide at any moment in time.

At **406,** the system **10** may continually compare the real time amount of stored energy available from the battery **12** (from **404**) with the minimum amount of energy **E_{M}** determined in 402.

When the amount of stored energy available from the battery **12** reaches the minimum amount of energy **E_{M}** required, the system may place the battery **12** into a hibernation mode (at **408**)**.** The battery **12** may preferably remain in hibernation mode until the user intentionally initiates the battery wake-up.

At **410,** the system **10** may receive a wake-up command initiated by the user, *e.g*., via the mobile application **110** running on the user's device **112** via Bluetooth or other communications protocols. Once the wake-up has been initiated, the system **10** may place the battery **12** in electrical communication with the car's starter so that the battery **12** may be used to start the car in the traditional manner (*e.g.,* using an ignition key).

### Additional Information:

To begin use of the battery management system **10,** the user may first install the system **10** with the battery **12.** The user may then run the mobile application **110** on his/her smartphone **112** and pair the device **112** with the system **10** (*e.g.,* via Bluetooth). The user may then enter information regarding the battery such as the battery name, date, amp hours of the battery, size of the associated car motor, and/or other information.

In some embodiments, once electrically configured with battery **12** and paired with the mobile application **110** and electronic device **112,** the system **10** may begin monitoring the battery's parameters as described herein. In some embodiments, as the system **10** collects information regarding the battery, the system **10** *(e.g.,* the controller **100**) may communicate at least some of the following information to the user: name of battery, input capacity of battery, temperature of the battery, balance levels of the battery's cells, the battery's state of charge, the remaining run time at the current load level, the battery's real time voltage, the battery's real time load current *(e.g.,* in watts, amps, etc.), the battery cell's internal resistance, number of cycles used by the battery *(e.g.,* to see the life cycles used), voltage difference(s) between battery cells, history of capacity, voltage, current, temperature, and/or other parameters and/or other information.

While monitoring the battery voltage levels, the system **10** may measure the voltage levels over time and the speed of any decreasing voltage to determine accuracy of discharge.

When monitoring battery discharge load levels, the system **10** may evaluate the speed of discharge in relation to the level of the current load over time to determine when the maximum discharge may occur.

When monitoring battery temperature, the system 10 may monitor the effect the temperature may have on the battery to ensure that in colder weather where capacity may be decreased the battery may still retain enough electrical energy to restart the vehicle.

When monitoring battery capacity, the system **10** may calculate the capacity in amp hours such that the system **10** may determine the battery's capable output current compared to larger amp hour batteries that can change the required capacity level need to restart the vehicle.

It is understood that any aspect or element of any embodiment of the system **10** and method described herein or otherwise may be combined with any other aspect or element of any other embodiment of the system **10** and method to form additional embodiments of the system **10** and method, all of which are within the scope of the system **10** and method.

Where a process is described herein, those of ordinary skill in the art will appreciate that the process may operate without any user intervention. In another embodiment, the process includes some human intervention (*e.g*., a step is performed by or with the assistance of a human).

As used in this description, the term "portion" means some or all. So, for example, "A portion of X" may include some of "X" or all of "X". In the context of a conversation, the term "portion" means some or all of the conversation.

As used herein, including in the claims, the phrase "at least some" means "one or more," and includes the case of only one. Thus, *e.g.,* the phrase "at least some ABCs" means "one or more ABCs," and includes the case of only one ABC.

As used herein, including in the claims, the phrase "based on" means "based in part on" or "based, at least in part, on," and is not exclusive. Thus, *e.g.,* the phrase "based on factor X" means "based in part on factor X" or "based, at least in part, on factor X." Unless specifically stated by use of the word "only," the phrase "based on X" does not mean "based only on X."

As used herein, including in the claims, the phrase "using" means "using at least," and is not exclusive. Thus, *e.g.,* the phrase "using X" means "using at least X." Unless specifically stated by use of the word "only", the phrase "using X" does not mean "using only X."

In general, as used herein, including in the claims, unless the word "only" is specifically used in a phrase, it should not be read into that phrase.

As used herein, including in the claims, the phrase "distinct" means "at least partially distinct." Unless specifically stated, distinct does not mean fully distinct. Thus, *e.g.,* the phrase, "X is distinct from Y" means that "X is at least partially distinct from Y," and does not mean that "X is fully distinct from Y." Thus, as used herein, including in the claims, the phrase "X is distinct from Y" means that X differs from Y in at least some way.

As used herein, including in the claims, a list may include only one item, and, unless otherwise stated, a list of multiple items need not be ordered in any particular manner. A list may include duplicate items. For example, as used herein, the phrase "a list of XYZs" may include one or more "XYZs".

It should be appreciated that the words "first" and "second" in the description and claims are used to distinguish or identify, and not to show a serial or numerical limitation. Similarly, the use of letter or numerical labels (such as "(a)", "(b)", and the like) are used to help distinguish and / or identify, and not to show any serial or numerical limitation or ordering.

No ordering is implied by any of the labeled boxes in any of the flow diagrams unless specifically shown and stated. When disconnected boxes are shown in a diagram, the activities associated with those boxes may be performed in any order, including fully or partially in parallel.

While the invention has been described in connection with what is presently considered to be the most practical and preferred embodiments, it is to be understood that the invention is not to be limited to the disclosed embodiments, but on the contrary, is intended to cover various modifications and equivalent arrangements included within the spirit and scope of the appended claims.

## Claims

1. A system for managing a battery comprising:
a controller including a wireless communication module;
an electrical measurement system electrically configured with the battery and in communication with the controller;
the controller adapted to:
measure, using the electrical measurement system, a stored electrical energy level of the battery;
store the measured stored electrical energy level in memory;
determine a minimum amount of stored electrical energy required to start a motor associated with the battery at least one time;
determine if the electrical energy level stored in memory is equal to or less than the determined minimum amount of stored electrical energy required to start the motor at least one time;
upon a determination that the electrical energy level stored in memory is equal to or less than the minimum amount of stored electrical energy required to start the motor at least one time, then:
place the battery into a hibernation mode;
receive, by the wireless communication module, a first wireless communication from a user of the battery to take the battery out of the hibernation mode; and
take the battery out of the hibernation mode.

2. The system of claim 1 wherein the controller is further adapted to, upon the determination that the stored electrical energy level in memory is equal to or less than the minimum amount of stored electrical energy required to start the motor at least one time, send, using the wireless communication module, a second wireless communication to the user of the battery regarding a first status of the battery.

3. The system of claim 2, wherein the first status of the battery includes information based at least in part on the electrical energy level stored in memory.

4. The system of claim 3, wherein the information includes a notification that the battery has been placed in the hibernation mode.

5. The system of any of the preceding claims, wherein the controller is further adapted to, after the battery has been taken out of the hibernation mode, send, using the wireless communication module, a third wireless communication to the user of the battery notifying the user that the battery has been taken out of the hibernation mode.

6. The system of any of the preceding claims, wherein the controller is further adapted to, after the battery is taken out of the hibernation mode, electrically configure the battery with the motor; and
use the battery to start the motor.

7. The system of any of the preceding claims, wherein the first wireless communication is a Bluetooth communication.

8. The system of claim 7, wherein the Bluetooth communication is initiated from an electronic device associated with the user.

9. The system of claim 8, wherein the electronic device is a smart device running at least one mobile application that implements the Bluetooth communication.

10. The system of any of the preceding claims, wherein when the battery is placed into the hibernation mode, the battery is electrically disconnected from at least one current drawing load.

11. The system of claim 10, wherein the at least one current drawing load includes one or more current drawing loads associated with the motor.

12. The system of any of claims 10 or 11, wherein the at least one current drawing load includes one or more current drawing loads associated with a battery management system.

13. The system of any of the preceding claims, wherein the minimum amount of stored electrical energy required to start the motor at least one time includes a minimum amount of stored electrical energy required to start the motor at least one or more times over a predefined period of time.

14. The system of claim 13, wherein the at least one or more times includes at least five times.

15. The system of any of claims 13 or 14, wherein the predefined period of time includes at least sixty days.
